# EUROPEAN PATENT SPECIFICATION

(11) **EP 2 111 779 B1**
(45) Date of publication and mention of the grant of the patent: **19.05.2010**
(21) Application number: 09009144.8
(22) Date of filing: 14.07.2009
(51) Int. Cl.: A47J 31/52, H03K 17/96

(54) **Automatic coffee machine having a control panel**
Automatische Kaffeemaschine mit Bedienfeld
Machine à café avec un panneau de commande

(30) Priority: 24.09.2008 IT MI20081691
(43) Date of publication of application: 28.10.2009
(73) Proprietor: De'Longhi SpA, 31100 Treviso (IT)
(72) Inventor: De' Longhi, Giuseppe, 31100 Treviso (IT)
(74) Representative: Rapisardi, Mariacristina

(56) References cited:
- EP-A- 1 749 464
- WO-A-03/044957
- US-A- 5 239 152

## Description

The present invention relates to an automatic coffee machine incorporating a control panel.

Presently, on a control panel for an automatic coffee machine, the user interface comprises a series of electro-mechanical switches for generating control and/or programming signals of the machine.

Electro-mechanical switches have several drawbacks, including the fact that the presence of dirt can compromise their correct operation.

For example, in the presence of dirt, it may be necessary to increase the pressure applied to the button to activate the switch, but excessive pressure could actually damage the switch.

A control panel with electro-mechanical switches also requires rather lengthy assembly times, due to the large number of components to be assembled.

One must also not overlook the fact that the presence of electro-mechanical switches can limit design choices for the shape of the control panel, which could as a result appear unattractive.

EP1749464 discloses an automatic coffee machine having a control panel using a scroll system to select a formulation or operating parameter.

The technical object of the present invention, therefore, is to provide an automatic coffee machine incorporating a control panel that can eliminate the technical drawbacks encountered by current technology.

In the context of this technical aim, an object of the invention is to provide an automatic coffee machine incorporating a control panel for that is extremely durable, reliable and functional.

Another object of the invention is to provide an automatic coffee machine incorporating a control panel that is easy to use.

A further object of the invention is to provide an automatic coffee machine incorporating a control panel that is economical and easily assembled, allowing for shorter assembly times and therefore an assembly procedure with increased productivity.

Yet another object of the invention is to provide an automatic coffee machine incorporating a control panel that is more attractive from the aesthetic point of view.

The technical aim, together with these and other objects of the present invention, are achieved by providing an automatic coffee machine incorporating a control panel corresponding to claim 1.

It should be noted that capacitive sensors are highly reliable and functional even in the presence of dirt and atmospheric variations such as temperature and humidity. In addition, the capacitive system guarantees a high degree of mechanical sturdiness, since no mechanical movement is involved, unlike the case with electro-mechanical switches.

The procedure for manufacturing the constituent parts of the control panel is well known and consolidated in applications for other technology sectors, while the assembly of the constituent parts of the control panel is greatly simplified given the small numbers of components involved.

Further features of the present invention are defined in the subsequent claims.

Other features and advantages of the invention will become more apparent from the following detailed, though not exclusive description of a preferred embodiment of the automatic coffee machine according to the invention, which is illustrated by way of non-limitative example in the accompanying drawings, in which:

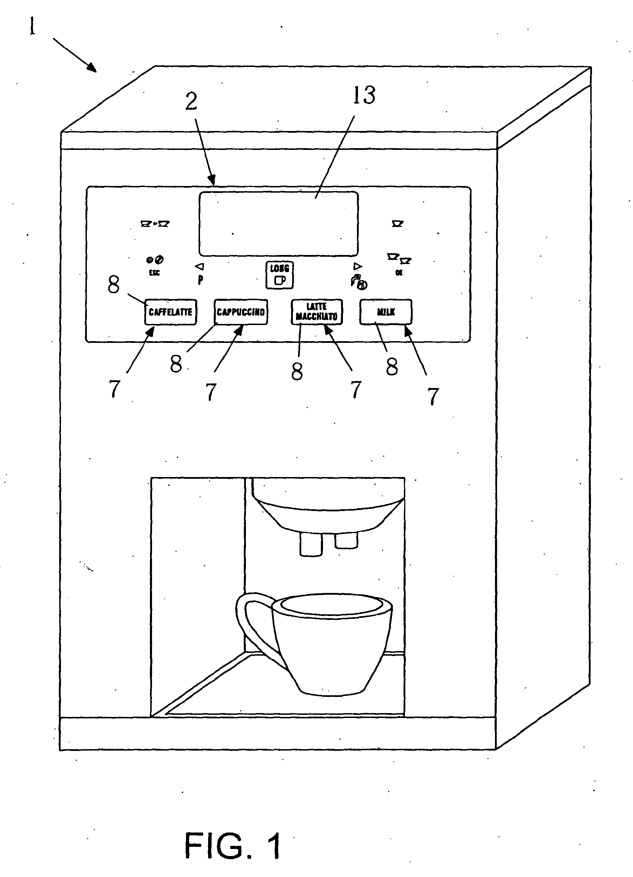

- Figure 1 shows a schematic elevated side view of an automatic coffee machine with a control panel corresponding to a preferred embodiment of the present invention;

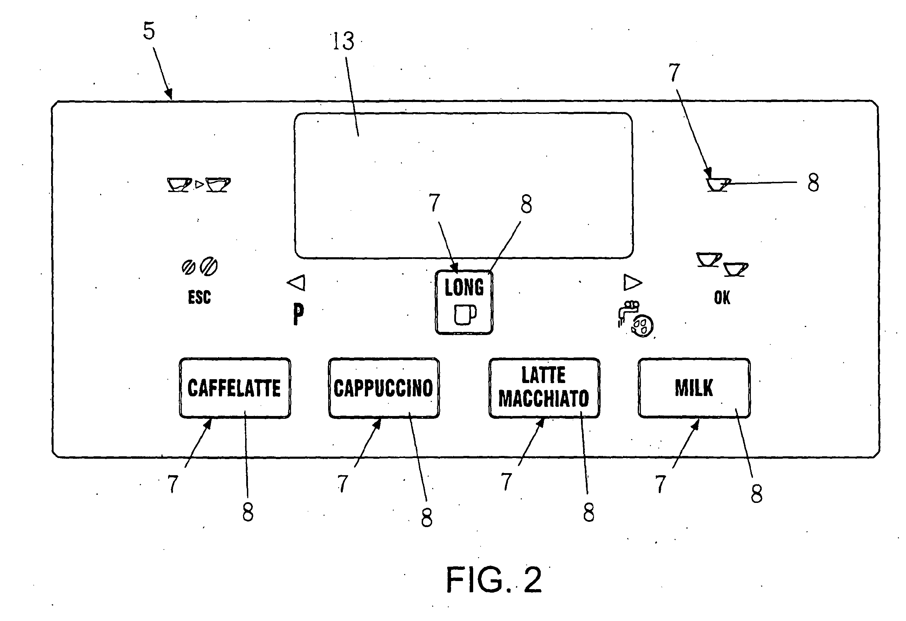

- Figure 2 shows a perspective view of the shield of the control panel shown in Figure 1;

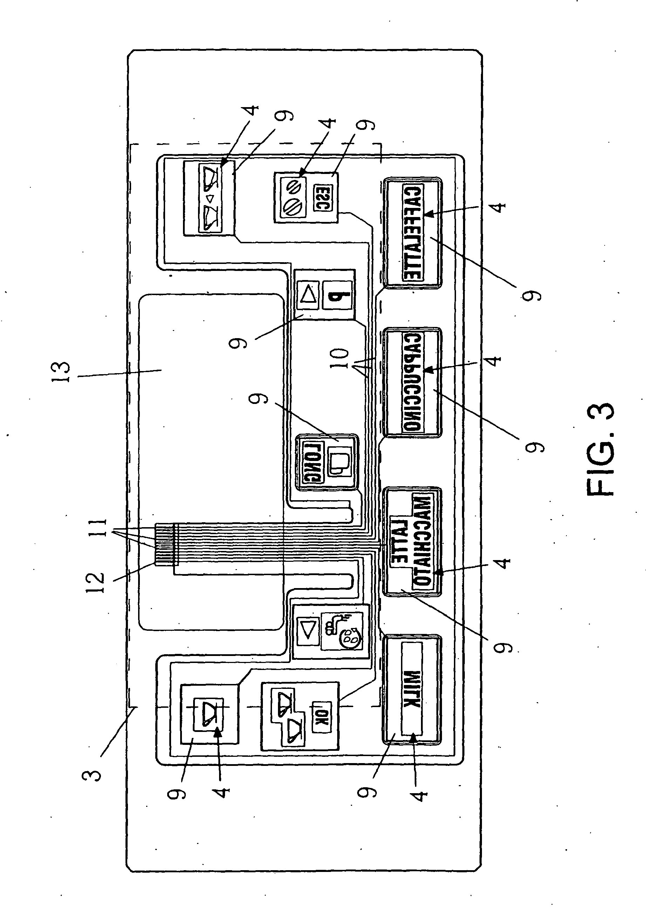

- Figure 3 shows a perspective view of the support for the capacitive sensors of the control panel shown in Figure 1; and

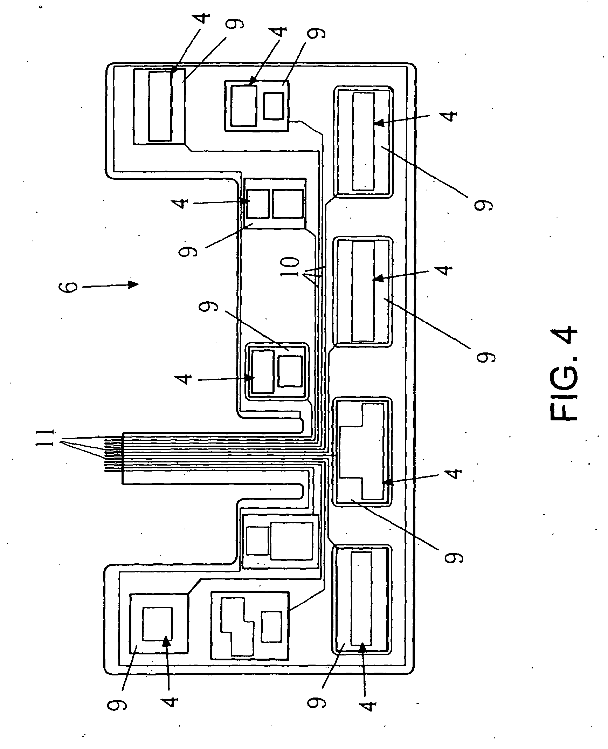

- Figure 4 shows a perspective view of the assembly formed by the shield and the support for the capacitive sensors, and the circuit board for controlling the machine shown in Figure 1.

With reference to the figures, an automatic coffee machine is shown, indicated by the reference number 1.

Generally speaking, the machine 1 comprises an infusion assembly fed by a pump which draws from a water tank.

Loading and/or withdrawal of coffee from the infusion chamber of the infusion assembly can be either manual or automatic.

A control panel 2 of the machine 1 is fitted with a user interface through which the user can send control and/or programming signals to a circuit board 3 for controlling the machine 1.

Advantageously, the user interface comprises a plurality of capacitive sensors 4 for generating the control and/or programming signals of the machine 1.

The interface structure comprises a shield 5 overlapped on a support 6 for the capacitive sensors 4.

The shield 5 has specific detection zones 7 marked by signs 8 for identifying a programme and/or control function.

Each detection zone 7 is overlapped onto an electrode 9 of a corresponding capacitive sensor 4.

The shield 5 is a thin panel of glass or plastic or other insulating material on which there is a printing material 15 with the identification marks 8 in negative.

The identification marks 8 are therefore delineated by the points of the shield 5 without printing material 15.

The support 6, on the other hand, presents the electrode 9 of each of the capacitive sensors 4 and electrically conductive tracks 10 with terminal contacts 11.

The support 6 is of the flexible type, and has an adhesive surface for joining it to the shield 5.

The support 6 structure comprises a sandwich formed of a first insulating base sheet on which the electrodes 9 and tracks 10 are deposited or printed, and a second protective sheet of insulating material that covers only the tracks 10, leaving the electrodes 9 uncovered.

The high flexibility conferred by said structure to the support 6 makes much more easy the assembly of the control panel regardless constructional tolerances in its components.

Furthermore, thanks to its own flexibility, the support 6 can perfectly adhere to the shield 5 by means of the adhesive applied in its surface. As a matter of fact the contact surface between the support 6 and the shield 5 is free from gaps or pockets where a fluid, for instance air or steam or moisture already existing in an environment inside a coffee machine, can flow so jeopardising the correct and effective transduction of the user inputs to capacitive sensors 4.

The terminal contacts 11 are arranged in a peripheral area of the support 6, and are connected to a connector 12 of the underlying circuit board 3.

Also connected to the circuit board 3 is a display 13, for example an LCD display, facing a window 14 in the shield 5.

The window 14 is also obtained in negative from the printing material 15.

The control panel also has a back-lighting system (not shown) for the detection zones 7 on the shield 5.

The back-lighting system preferably has a selector switch for selecting only some of the detection zones 7 intended to be lit even when the machine 1 is off.

The function with which a detection zone 7 marked by an identification sign 8 is associated, may be the command to prepare coffee with milk, or the command to prepare a cappuccino, or the command to prepare milk with a dash of coffee, or the command to prepare milk, or the command to perform a rinse cycle on the hydraulic circuit of the infusion assembly, or the selection of a specific operating parameter of the machine 1 for the execution of the infusion, such as the quantity of water or coffee and/or the infusion time.

The function with which a detection zone 7 is associated, may be the function giving access to the machine 1 settings, for example to be able to set the preferred language, time, infusion temperature, automatic switching on and off of the machine 1, decalcification and the hardness of the water.

Operation of the control panel according to the invention appears evident from what has been described and illustrated.

The user's finger, when it enters the detection zone 7, acts as a second electrode which, together with the electrode 9 below the detection zone 7, constitutes a capacitive element detected by the circuit board 3, which then controls switching of the output signal.

The coffee machine thus conceived may be subject to several modifications and variants, all of which fall within the ambit of the invention; in addition, all the components can be replaced by technically equivalent elements.

In practice, the materials used, as well as the dimensions, can be adapted depending on needs and the state of the art.

## Claims

1. Automatic coffee machine (1) **characterised in that** of having a control panel (2) with a user interface comprising a plurality of capacitive sensors (4) for generating control and/or programming signals of said machine (1), said interface comprising a shield (5) overlapped on a flexible support (6) for said capacitive sensors (4), said shield (5) having specific detection zones (7) marked by signs (8) for identifying a programme and/or control function, each of said detection zones (7) being overlapped onto an electrode (9) of a corresponding one of said capacitive sensors (4), said flexible support (6) presenting said electrode (9) for said capacitive sensors (4) and electrically conductive tracks (10) having terminal contacts (11) connected to a connector (12) of printed circuit board (3) of management of said machine (1).

2. Automatic coffee machine (1) according to claim 1, **characterised in that** said support (6) has a structure comprising a sandwich formed of a first insulating base sheet on which said electrodes (9) and said tracks (10) are deposited or printed, and a second protective sheet of insulating material that covers only said tracks (10), leaving said electrodes (9) uncovered.

3. Automatic coffee machine (1) according to one or more previous claims, **characterised in that** said support (6) has an adhesive surface for joining to said shield (5).

4. Automatic coffee machine (1) according to one or more of the preceding claims, **characterised in that** said contact terminals (11) are arranged in a peripheral area of said support (6).

5. Automatic coffee machine (1) according to one or more of the preceding claims, **characterised in that** said shield (5) is a panel made of insulating material in which is a printing material (15) having said identification marks (8) in negative.

6. Automatic coffee machine (1) according to one or more of the preceding claims, **characterised in that** said support (6) is overlapped onto said printed circuit board (3) of management of said machine (1).

7. Automatic coffee machine (1) according to one or more of the preceding claims, **characterised in that** connected to said circuit board (3) of management of said machine (1) is a display (13) facing a window (14) of said shield (5).

8. Automatic coffee machine (1) according to one or more of the preceding claims, **characterised in that** said window (14) is obtained in negative from said printing material (15).

9. Automatic coffee machine (1) according to one or more of the preceding claims, **characterised in that** it has a rear lighting system for said detection zones (7) of said shield (5).

10. Automatic coffee machine (1) according to one or more of the preceding claims, **characterised in that** said rear lighting system has a selector switch for selecting only some of said detection zones (7) intended to be lighted even when said machine (1) is off.

## Patentansprüche

1. Automatische Kaffeemaschine (1), **dadurch gekennzeichnet, dass** sie ein Bedienfeld (2) mit einer Benutzerschnittstelle hat, die aus einer Mehrzahl von kapazitativen Sensoren (4) zum Erzeugen von Signalen zum Steuern und/oder Programmieren der Kaffeemaschine (1) besteht, wobei genannte Schnittstelle eine auf eine flexible Auflage (6) für genannte kapazitative Sensoren (4) aufgesetzte Abdeckmaske (5) umfasst, wobei genannte Abdeckmaske (5) spezifische durch Symbole (8) zum Erkennen einer Programmier- und/oder Steuerfunktion angezeigte Erfassungsbereiche (7) hat, wobei jeder dieser Erfassungsbereiche (7) auf einer Elektrode (9) eines entsprechenden kapazitativen Sensors (4) aufliegt, wobei genannte flexible Auflage (6) genannte Elektrode (9) für genannte kapazitative Sensoren (4) und Leiterbahnen (10) mit Endkontakten (11) aufweist, die an einen Verbinder (12) der gedruckten Schaltung (3) zur Verwaltung der genannten Kaffeemaschine (1) angeschlossen sind.

2. Automatische Kaffeemaschine (1) nach Anspruch 1, **dadurch gekennzeichnet, dass** die Struktur der genannten Auflage (6) aus einem Sandwich gebildet ist, bestehend aus einer ersten isolierenden Grundschicht, auf der die genannten Elektroden (9) und die genannten Leiterbahnen (10) aufgeschweißt oder aufgedruckt sind, und einer zweiten Schutzschicht aus isolierendem Material, welche die genannten Leiterbahnen (10) bedeckt, aber die genannten Elektroden (9) freilässt.

3. Automatische Kaffeemaschine (1) nach einem oder mehreren vorstehenden Ansprüchen, **dadurch gekennzeichnet, dass** genannte Auflage (6) eine Klebefläche für die Verbindung mit genannter Abdeckmaske (5) hat.

4. Automatische Kaffeemaschine (1) nach einem oder mehreren vorstehenden Ansprüchen, **dadurch gekennzeichnet, dass** genannte Endkontakte (11) in einem äußerem Bereich der genannten Auflage (6) angeordnet sind.

5. Automatische Kaffeemaschine (1) nach einem oder mehreren vorstehenden Ansprüchen, **dadurch gekennzeichnet, dass** genannte Abdeckmaske (5) eine Platte aus isolierendem Material ist, auf die ein Druckmaterial (15) aufgetragen ist, dass genannte Symbole (8) im Negativ aufweist.

6. Automatische Kaffeemaschine (1) nach einem oder mehreren vorstehenden Ansprüchen, **dadurch gekennzeichnet, dass** genannte Auflage (6) auf genannter gedruckter Schaltung (3) zur Verwaltung genannter Kaffeemaschine (1) aufliegt.

7. Automatische Kaffeemaschine (1) nach einem oder mehreren vorstehenden Ansprüchen, **dadurch gekennzeichnet, dass** an genannte gedruckte Schaltung (3) zur Verwaltung genannter Kaffeemaschine (1) ein Sichtgerät (13) angeschlossen ist, das auf ein Fenster (14) der genannten Abdeckmaske (5) gerichtet ist.

8. Automatische Kaffeemaschine (1) nach einem oder mehreren vorstehenden Ansprüchen, **dadurch gekennzeichnet, dass** genanntes Fenster (14) aus genanntem Druckmaterial (15) im Negativ erhalten ist.

9. Automatische Kaffeemaschine (1) nach einem oder mehreren vorstehenden Ansprüchen, **dadurch gekennzeichnet, dass** sie ein Rückbeleuchtungssystem für genannte Erfassungsbereiche (7) genannter Abdeckmaske (5) aufweist.

10. Automatische Kaffeemaschine (1) nach einem oder mehreren vorstehenden Ansprüchen, **dadurch gekennzeichnet, dass** genanntes Rückbeleuchtungssystem einen Wahlschalter aufweist, um nur einige der Erfassungsbereiche (7) zu wählen, die auch bei ausgeschalteter Kaffeemaschine (1) beleuchtet werden können.

## Revendications

1. Machine à café automatique (1) **caractérisée par le fait qu'**elle possède un panneau de commande (2) avec une interface utilisateur comprenant plusieurs capteur capacitifs (4) pour la génération de commande et/ou la programmation des signaux de ladite machine (1), ladite interface comprenant une plaque de protection (5) recouvrant un support flexible (6) pour lesdits capteurs capacitifs (4), ladite plaque de protection (5) ayant des zones de détection spécifiques (7) repérées par des signes (8) pour identifier un programme et/ou une fonction de commande, chacune desdites zones de détection (7) recouvrant une électrode (9) de l'un desdits capteurs capacitifs correspondant (4), ledit support flexible (6) présentant ladite électrode (9) pour lesdits capteurs capacitifs (4) et des pistes conduisant l'électricité (10) ayant des bornes de contacts (11) reliées à un connecteur (12) de carte de circuit imprimé (3) de gestion de ladite machine (1).

2. Machine à café automatique (1) selon la revendication 1, **caractérisée par le fait que** ledit support (6) possède une structure comprenant un sandwich formé d'une première feuille de base d'isolation sur laquelle lesdites électrodes (9) et lesdites pistes (10) sont déposées ou imprimées, et une deuxième feuille de protection en matériau isolant qui couvre seulement lesdites pistes (10), laissant lesdites électrodes (9) découvertes.

3. Machine à café automatique (1) selon un ou plusieurs des revendications précédentes, **caractérisée par le fait que** ledit support (6) possède une surface adhésive pour la jonction avec ladite plaque de protection (5).

4. Machine à café automatique (1) selon un ou plusieurs des revendications précédentes, **caractérisée par le fait que** lesdits bornes de contact (11) sont disposées dans une zone périphérique dudit support (6).

5. Machine à café automatique (1) selon un ou plusieurs des revendications précédentes, **caractérisée par le fait que** ladite plaque de protection (5) est un panneau réalisé en matériau isolant sur lequel se trouve un matériel d'impression (15) ayant lesdits signes d'identification (8) en négatif.

6. Machine à café automatique (1) selon un ou plusieurs des revendications précédentes, **caractérisée par le fait que** ledit support (6) recouvre ladite carte de circuit imprimé (3) de gestion de ladite machine (1).

7. Machine à café automatique (1) selon un ou plusieurs des revendications précédentes, **caractérisée par le fait qu'**un écran (13) face à une fenêtre (14) de ladite plaque de protection (5) se trouve raccordé à ladite carte de circuit imprimé (3) de gestion de ladite (1).

8. Machine à café automatique (1) selon un ou plusieurs des revendications précédentes, **caractérisée par le fait que** ladite fenêtre (14) est obtenue en négatif à partir dudit matériel d'impression (15).

9. Machine à café automatique (1) selon un ou plusieurs des revendications précédentes, **caractérisée par le fait qu'**elle dispose d'un système de rétro-éclairage pour lesdites zones de détection (7) de ladite plaque de protection (5).

10. Machine à café automatique (1) selon un ou plusieurs des revendications précédentes, **caractérisée par le fait que** ledit système de rétro-éclairage possède un interrupteur de sélection pour sélectionner uniquement certaines des zones de détection (7) prévues pour être éclairées même lorsque ladite machine (1) est arrêtée.
